# EUROPÄISCHE PATENTSCHRIFT

(11) **EP 1 078 402 B1**
(45) Veröffentlichungstag und Bekanntmachung des Hinweises auf die Patenterteilung: **30.08.2006**
(21) Anmeldenummer: 99906026.2
(22) Anmeldetag: 07.01.1999
(51) Int. Cl.: H01L 29/06, H01L 29/739, H01L 21/331

(54) **HALBLEITERANORDNUNG MIT GRÄBEN ZUR TRENNUNG VON DOTIERTEN GEBIETEN**
SEMICONDUCTOR SYSTEM WITH TRENCHES FOR SEPARATING DOPED AREAS
DISPOSITIF A SEMI-CONDUCTEUR AVEC TRANCHEES DESTINEES A SEPARER LES ZONES DOPEES

(43) Veröffentlichungstag der Anmeldung: 28.02.2001
(73) Patentinhaber: Infineon Technologies AG, 81669 München (DE)
(72) Erfinder: PFIRSCH, Frank, D-81545 München (DE)
(74) Vertreter: Patentanwälte Westphal, Mussgnug & Partner
(86) Internationale Anmeldenummer: PCT/DE1999/000012
(87) Internationale Veröffentlichungsnummer: WO 2000/041246

(56) Entgegenhaltungen:
- GB-A- 2 314 206
- US-A- 3 994 011
- US-A- 5 430 324
- US-A- 5 525 821

## Beschreibung

Eines der häufigen Probleme bei der Herstellung von Halbleiterbauelementen ist die effektive Trennung von dotierten Gebieten im Halbleitersubstrat. Diese Problematik tritt insbesondere dann auf, wenn in einem Halbleiterbauelement dotierte Gebiete vorkommen, die relativ weit eindiffundiert sind. Beispiele dafür sind CMOS-Wannen in integrierten Schaltkreisen oder ringförmige Dotierungsgebiete, die in Leistungstransistoren oder IGBT's das Zellenfeld umgeben und den im Randbereich fließenden Strom abführen sollen. In vielen Fällen sollen diese Gebiete von anderen Dotierungsgebieten räumlich und elektrisch getrennt sein.

Eine Möglichkeit, dotierte Gebiete elektrisch und räumlich zu trennen, bestünde darin, sie mit so großem Abstand zu implantieren, daß sie bei den nachfolgenden Diffusionsprozessen nicht ineinanderdiffundieren, sondern einen hinreichend großen Abstand behalten. Der Abstand der Implantationen muß dabei um die Summe der Weiten der Ausdiffusion der Dotierungsgebiete größer sein als der am Ende des Herstellungsprozesses gewünschte Abstand. Bei tiefen Diffusionsgebieten ergeben sich daher unerwünscht große Strukturen.

In US 5,525,821 wird eine Methode beschrieben, bei der zunächst Diffusionsgebiete erzeugt werden, und diese anschließend durch tiefe Grabenstrukturen voneinander getrennt werden. Durch diese Methode können zwar Strukturen mit geringer lateraler Ausdehnung hergestellt werden. Allerdings besteht der Nachteil, daß die Tiefe der Gräben mindestens die Tiefe der Diffusionsgebiete erreichen muß. Folge sind somit aufwendigere Strukturierungsschritte und andererseits Einschränkungen, wenn vorgesehen werden soll, gleichzeitig mit den Gräben zur Trennung der Diffusionsgebiete auch Gräben herzustellen, die beispielsweise für Grabentransistoren genutzt werden sollen. Nachdem die Tiefe der Gräben bereits durch die Diffusionsgebiete vorgegeben ist, bleiben keine ausreichenden Strukturierungsfreiheiten mehr für eine Optimierung der Grabentransistoren.

Eine Trennung von Diffusionsgebieten durch Gräben, die auch eine geringere Tiefe aufweisen dürfen als die Diffusionsgebiete, ist aus US 5,430,324 oder GB 2 314 206 bekannt. Hier besteht allerdings wiederum die Problematik, daß zunächst eine Implantation von Dotierungsgebieten in ausreichend großem Abstand erfolgen muß. Andernfalls besteht die Gefahr, daß durch die geringe Tiefe der Gräben keine ausreichende räumliche und elektrische Trennung der dotierten Gebiete gewährleistet ist.

Aufgabe der vorliegenden Erfindung ist es daher, eine Möglichkeit zur effektiven Trennung von dotierten Gebieten durch Gräben in einem Halbleitersubstrat bereitzustellen, die möglichst kleine Strukturgrößen und möglichst große Freiheiten bei der Gestaltung der Gräben erlaubt.

Diese Aufgabe wird gelöst durch die Merkmale des vorliegenden Anspruchs 1. Ein Verfahren zur Herstellung einer solchen Anordnung ergibt sich aus den Merkmalen des Anspruchs 14.

Wie bereits beschrieben kann die Notwendigkeit zur Trennung von dotierten Gebieten in unterschiedlichen Bereichen einer Halbleiteranordnung auftreten. So kann es notwendig sein, dotierte Gebiete beispielsweise im aktiven Bereich einer Halbleiteranordnung, also in demjenigen Bereich, in dem die Transistoren angeordnet sind, zu trennen. Ebenso kann der Fall auftreten, daß dotierte Gebiete im Bereich der Randstrukturen der Halbleiteranordnung, also zwischen der Transistoranordnung und dem Substratrand, voneinander getrennt werden müssen. In einem solchen Bereich können beispielsweise dotierte Gebiete zwischen der Transistoranordnung und dem Substratrand vorgesehen sein, die sich von der Oberfläche des Substrats in das Substrat erstrecken und die Transistoranordnung als Ring umgeben. Die Transistoranordnung selbst kann dabei aus einer beliebigen Anzahl und Art von Transistoren bestehen. Insbesondere können dabei Transistoren Verwendung finden, die als Feldeffekt-Transistoren ausgebildet sind und mindestens zwei in das Substrat eingebettete dotierte Gebiete sowie mindestens eine Gate-Elektrode aufweisen. Grundsätzlich können jedoch auch beispielsweise Bipolar-Transistoren vorgesehen sein.

Zu einer effektiven Trennung der dotierten Gebiete werden nun mindestens je zwei benachbarte, isolierende Grabengebiete vorgesehen, die zwischen den dotierten Gebieten angeordnet sind und sich von der Oberfläche des Substrats aus in das Substrat erstrecken. Somit befindet sich erfindungsgemäß zwischen zwei dotierten Gebieten nicht nur ein einzelner Graben, der unter Umständen für eine effektive Trennung nicht ausreicht, sondern es werden zwei oder mehrere Gräben zwischen den dotierten Gebieten angeordnet. Damit kann erreicht werden, daß auch mit Gräben geringerer Tiefe, die kleiner ist als die Tiefe der dotierten Gebiete, noch eine sehr gute elektrische und räumliche Trennung der dotierten Gebiete erzielt werden kann. Die Tiefe der Gräben kann dabei an die Gegebenheiten beispielsweise zur Erzeugung von Trenchtransistoren angepaßt werden.

Wie beschrieben bietet die vorliegende Erfindung relativ große Freiheiten bei der Gestaltung der Tiefe der Gräben zur Trennung der dotierten Gebiete. So können diese Gräben eine Tiefe aufweisen, die geringer ist als die Tiefe der dotierten Gebiete. Natürlich können auch Gräben vorgesehen werden, deren Tiefe der Tiefe der dotierten Gebiete entspricht oder deren Tiefe größer ist als die Tiefe der dotierten Gebiete.

Die Gräben können mit unterschiedlichen Materialien gefüllt sein. So kann beispielsweise vorgesehen werden, daß jedes Grabengebiet oder zumindest ein Teil der Grabengebiete mit einer Isolationsschicht gefüllt ist bzw. durch eine Isolationsschicht gebildet wird. Alternativ kann jedoch auch vorgesehen sein, daß im Grabengebiet eine leitende Schicht vorhanden ist, die von einer Isolationsschicht umgeben ist. Es muß lediglich gewährleistet sein, daß eine ausreichende Isolation der dotierten Gebiete gegeneinander erzielt werden kann. Somit können für die Isolationsschicht bzw. die leitende Schicht im Grabengebiet auch unterschiedliche Materialien gewählt werden, die an die jeweiligen Gegebenheiten angepaßt werden können. So kann als Isolationsschicht beispielsweise eine Oxidschicht oder eine Nitridschicht vorgesehen werden, als leitende Schicht beispielsweise eine Polysiliziumschicht.

Werden Grabengebiete vorgesehen, die eine leitende Schicht beinhalten, so kann eine leitende Verbindung der einzelnen Grabengebiete untereinander vorgesehen werden. Man erzielt damit, daß die untereinander verbundenen Grabengebiete auf einem einheitlichen Potential gehalten werden können. Dabei kann zur Erzielung eines genau definierten Potentials vorgesehen werden, daß einzelne oder alle der Gräben, die eine leitende Schicht aufweisen, mit einer der Elektroden der Transistoranordnung verbunden werden, beispielsweise mit einer Gateelektrode oder einer Katodenelektrode. So kann beispielsweise vorgesehen werden, daß zumindest die innersten Grabengebiete, die der Transistoranordnung am nächsten angeordnet sind, mit einer Gateelektrode oder einer Katodenelektrode leitend verbunden sind.

Die dotierten Gebiete können sowohl als floatende Gebiete ausgebildet sein, als auch auf einem definierten Potential durch eine leitende Verbindung, beispielsweise mit einer Elektrode der Transistoranordnung, gehalten werden. Bevorzugt wird vorgesehen, daß zumindest das innerste dotierte Gebiet, das an die Transistoranordnung angrenzt, als floatendes Gebiet ausgebildet ist, also nicht auf einem definierten Potential gehalten wird. Dies ist insbesondere dann sinnvoll, wenn im Bereich der Transistoranordnung eine möglichst gute Trägerüberschwemmung gewünscht ist, wie dies bei Trench-IGBT's der Fall ist.

Andererseits wird bevorzugt vorgesehen, daß zumindest das äußerste dotierte Gebiet, das dem Substratrand am nächsten liegt, mit einer Elektrode der Transistoranordnung, insbesondere mit einer Katodenelektrode, leitend verbunden ist. Dadurch kann erreicht werden, daß Löcher aus dem Randbereich bei Schaltvorgängen effektiver abgeführt werden können und so das Schaltverhalten der Halbleiteranordnung optimiert werden kann.

Es wurde beschrieben, daß die erfindungsgemäße Idee für eine Anordnung verwendet werden kann, die zwischen dem aktiven Bereich einer Halbleiteranordnung, also der Transistoranordnung und dem Substratrand angeordnet sein kann. Es kann dabei weiter vorgesehen werden, daß zwischen der erfindungsgemäßen Anordnung und dem eigentlichen Substratrand noch weitere Randstrukturen vorgesehen werden. So können in diesem Bereich beispielsweise noch Feldplatten oder Feldringe sowie ein Kanalstopper vorgesehen werden. Es ist auch möglich, eine Kombination dieser einzelnen Randstrukturelemente vorzusehen. So können beispielsweise mehrere Feldplatten und Feldringe vorgesehen sein, wobei jeweils ein Feldring mit einer Feldplatte verbunden ist. Diese Kombination aus Feldplatte mit Feldring kann zu der jeweils benachbarten Kombination aus Feldplatte und Feldring ebenfalls in unterschiedlicher Weise angeordnet sein. So kann vorgesehen sein, daß keinerlei Überlappung dieser Anordnungen untereinander vorgesehen ist. Eine solche Anordnung ohne jegliche Überlappung kann beispielsweise im Außenbereich der Randstruktur, also in der Nähe des Substratrandes, vorgesehen werden. Andererseits kann auch eine Überlappung der Feldplatte der einen Kombination aus Feldplatte und Feldring mit dem Feldring der nächsten Kombination aus Feldplatte und Feldring in Form einer Kaskodenschaltung vorgesehen sein. Eine solche Anordnung wird bevorzugt für denjenigen Bereich der Randstruktur vorgeschlagen, der der Transistoranordnung am nächsten liegt. Die Feldplatten oder die Feldringe der Randstruktur können durch eine leitende Verbindung zu einer Elektrode der Transistoranordnung auf einem definierten Potential gehalten werden.

Auch für den Kanalstopper, der in der Regel unmittelbar am Substratrand angeordnet ist, können unterschiedliche Ausgestaltungsformen realisiert werden. So kann beispielsweise der Kanalstopper allein aus einer dotierten Schicht bestehen, die den selben Leitungstyp aufweist wie das Substrat oder den entgegengesetzten Leitungstyp, und die am Rand des Substrats angeordnet ist. Der Kanalstopper kann jedoch auch durch eine Kombination einer solchen Schicht mit einer Feldplatte gebildet werden, die beide leitend miteinander verbunden sind. In einer weiteren Ausführungsform kann vorgesehen werden, daß die dotierte Schicht des Kanalstoppers von einer weiteren Schicht entgegengesetzten Leitungstyps umgeben ist. Damit wird die Wirkung der dotierten Schicht als Kanalstopper reduziert und die eigentliche Wirkung des Kanalstoppers weitgehend auf die Feldplatte beschränkt.

Im folgenden wird ein erfindungsgemäßes Verfahren beschrieben, das die Herstellung einer Halbleiteranordnung erlaubt, die mindestens zwei baulich und elektrisch voneinander getrennte dotierte Gebiete aufweist. Hierbei wird zunächst ein Dotierstoff im Bereich der zu erzeugenden Gebiete in ein Halbleitersubstrat eingebracht. Das Einbringen des Dotiermaterials in das Halbleitersubstrat kann auf unterschiedliche Weise erfolgen, wobei alle bekannten Verfahren aus dem Stand der Technik Anwendung finden können. Es kann beispielsweise vorgesehen werden, daß der Dotierstoff mittels einer Implantation in das Halbleitersubstrat eingebracht wird, wobei die Implantation durch ein Streuoxid auf der Oberfläche des Substrats erfolgt. Nach der Einbringung des Dotierstoffes kann ein erster Diffusionsschritt vorgesehen sein, der zu einer Ausdiffusion des Dotierstoffes in eine Tiefe führt, die geringer ist als die gewünschte Tiefe der späteren fertigen dotierten Gebiete. Der erste Diffusionsschritt kann jedoch auch entfallen, so daß lediglich in einem ersten Schritt eine geeignete Implantation erfolgt.

Der Abstand, in dem diese Gebiete in das Substrat eingebracht werden, sollte dabei etwas größer gewählt werden als der gewünschte Abstand der komplett ausgebildeten späteren Gebiete. Der Abstand muß jedoch nicht größer gewählt werden, als die Summe aus dem später gewünschten Strukturabstand und - im Falle eines ersten Diffusionsschrittes - der doppelten Weite der Ausdiffusion im ersten Diffusionsschritt.

Im Anschluß an den die Einbringung des Dotierstoffes erfolgt die Erzeugung je eines Grabens an derjenigen Grenze jedes der dotierten Gebiete, die dem jeweils anderen Gebiet zugewandt ist. Der Graben muß dabei lediglich eine Tiefe aufweisen, die größer ist als die Tiefe der Gebiete nach der Einbringung des Dotierstoffes und gegebenenfalls nach einer anschließenden ersten Ausdiffusion. Die Tiefe des Grabens kann jedoch geringer gewählt werden als die Tiefe der späteren dotierten Gebiete. Ist nun beispielsweise die Tiefe der Gräben durch einen entsprechenden Strukturierungsschritt zur gleichzeitigen Herstellung von Grabentransistoren vorgegeben, so kann die Einbringung des Dotierstoffes und gegebenenfalls ein erster Ausdiffusionsschritt an diese Vorgaben angepaßt werden, damit die Einbringung des Dotierstoffes und eine eventuelle erste Ausdiffusion nicht die Tiefe der Gräben überschreitet.

Nach der Herstellung der Gräben erfolgt eine zweite Ausdiffusion des Dotierstoffes in die gewünschte Tiefe, die in der Regel größer sein wird als die Tiefe der Gräben. Da jedoch mindestens zwei Gräben zwischen jeweils zwei dotierten Gebieten erzeugt wurden, besteht trotz einer Ausdiffusion in eine größere Tiefe als die Tiefe der Gräben nicht die Gefahr, daß die dotierten Gebiete durch die Ausdiffusion ineinander übergehen oder eine ausreichende räumliche Trennung nicht mehr gewährleistet ist.

Die gebildeten Gräben können anschließend durch eine isolierende Schicht aufgefüllt werden. Diese kann vollständig aus Isolationsmaterial wie einem Oxid oder einem Nitrid bestehen oder sie kann als Mehrschichtstruktur ausgebildet werden, wobei zunächst der Graben mit einer isolierenden Schicht ausgekleidet wird und dann mit einer weiteren Schicht, beispielsweise aus leitendem Material, gefüllt wird. So kann beispielsweise zur Bildung der isolierenden Schicht eine Isolationsschicht auf den Innenseiten der Gräben und auf der Oberfläche des Substrats erzeugt werden, beispielsweise durch eine Oxidation des Halbleitersubstrats zur Bildung von Siliziumoxid, worauf der Graben anschließend mit einer leitenden Schicht aufgefüllt wird, beispielsweise mit Polysilizium.

Ein spezielles Ausführungsbeispiel der vorliegenden Erfindung wird anhand der Figuren 1 bis 7 sowie der nachfolgenden Beschreibung erläutert.

Es zeigen:
- Figur 1:: Querschnitt durch eine Halbleiteranordnung mit einem Trench-IGBT sowie einer Randstruktur.
- Figur 2:: Alternative Ausführungsform der Randstruktur gemäß Figur 1.
- Figuren 3 bis 7:: Verfahrensschritte zur Herstellung zweier dotierter Gebiete, die durch zwei isolierende Grabengebiete voneinander getrennt werden.

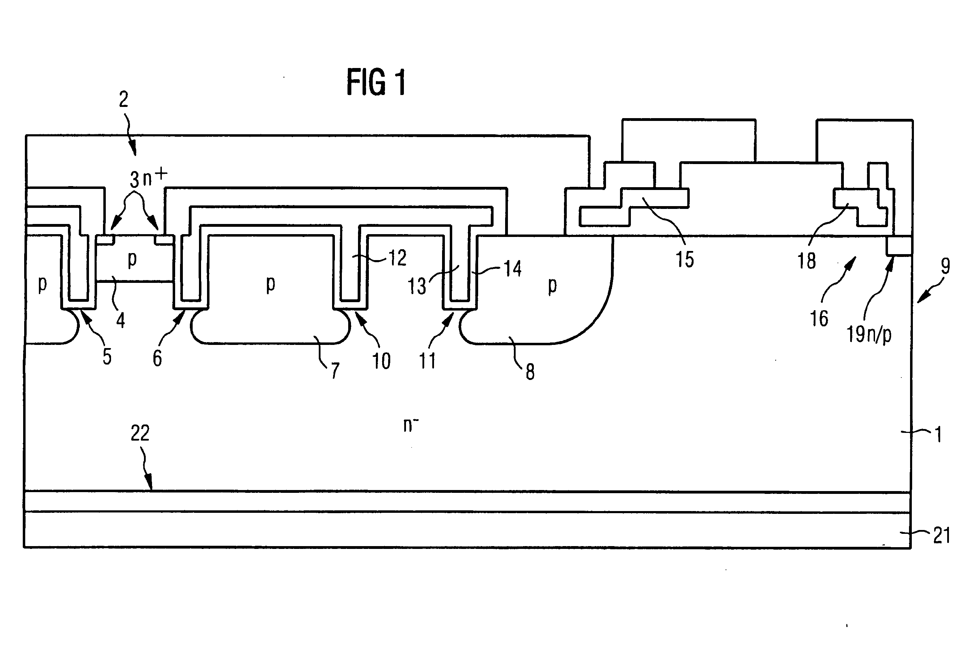

Figur 1 zeigt eine Halbleiteranordnung, bei der als Teil einer Transistoranordnung 2 ein IGBT mit zwei grabenförmigen Gate-Elektroden 5, 6 dargestellt ist, wobei ein p-Bodygebiet 4 und n⁺-Sourcegebiete 3 in ein n-Substrat 1 eingebettet sind. In dem Substrat 1 ist weiterhin eine Anodenschicht 22 vom Leitungstyp p vorgesehen, auf die eine Rückseitenmetallisierung 21 aufgebracht ist. Weiterhin erstrecken sich zwei dotierte Gebiete vom Typ p 7 und 8 in das Substrat 1. Diese beiden Gebiete sind durch zwei Gräben 10 und 11 voneinander getrennt. Jeder der Gräben 10, 11 ist mit einer Isolationsschicht 14 ausgekleidet, wobei hierfür die selbe Schicht verwendet wurde, die auch die Gateoxidschicht der Gate-Elektroden 5, 6 bildet. Weiterhin sind die Gräben 10, 11 mit einer leitenden Schicht 12 und 13 gefüllt, die durch die selbe Schicht gebildet wird, wie die leitende Schicht der Gate-Elektroden. Die Gräben 10 und 11 können somit gleichzeitig in einem Strukturierungsschritt mit den Gate-Elektroden 5, 6 erzeugt werden. Die Isolationsschicht 14 kann dabei als Oxidschicht vorgesehen sein, die leitenden Schichten 12, 13 als Polysiliziumschichten.

Das dotierte Gebiet 7, das an die Gate-Elektrode 6 des IGBT angrenzt, ist als floatendes Gebiet vorgesehen. Damit kann beim Betrieb des IGBT eine verbesserte Trägerüberschwemmung gewährleistet werden. Das zweite dotierte Gebiet 8 dagegen ist leitend mit den Source-Gebieten 3 verbunden. Dieses Gebiet wird somit auf Source-Potential gehalten.

Zwischen den dotierten Gebieten 7, 8 und dem Substratrand 9 ist eine Randstruktur vorgesehen, die im Ausführungsbeispiel nach Figur 1 durch Feldplatten sowie einen Kanalstopper gebildet wird. Hierzu ist beispielhaft eine Feldplatte 15 dargestellt, die in eine Oxidschicht eingebettet ist und über dem Substrat 1 angeordnet ist. Die Feldplatte 15 ist entweder mit einer Source-Elektrode 3 oder einer Gate-Elektrode 5, 6 leitend verbunden. Der Kanalstopper 16 wird gebildet durch eine dotierte Schicht 19, die entweder vom Leitungstyp n oder vom Leitungstyp p sein kann, und die direkt am Substratrand 9 angeordnet ist. Diese dotierte Schicht ist leitend mit einer Feldplatte 18 verbunden, die ebenfalls in eine Oxidschicht eingebettet und über dem Substrat 1 angeordnet ist.

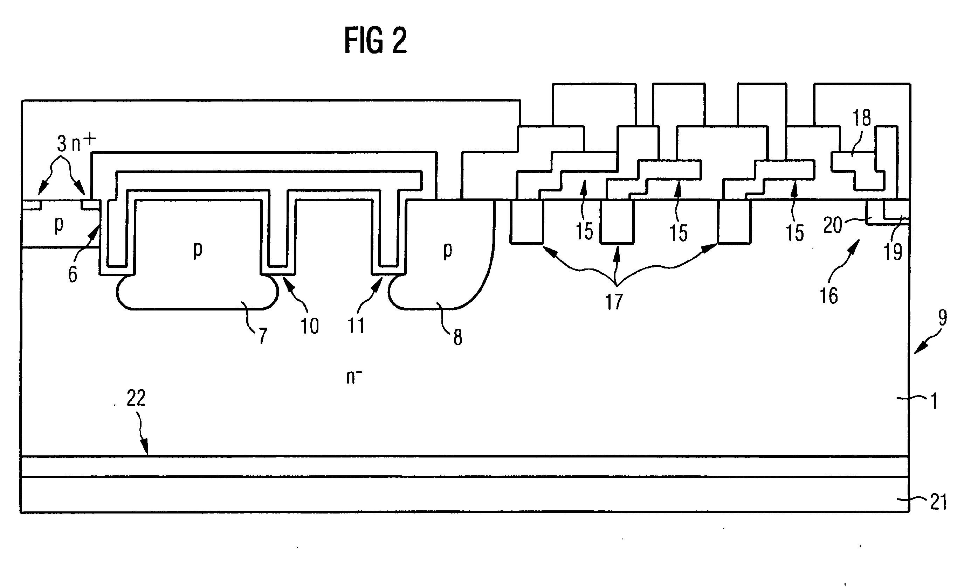

Eine alternative Ausführungsform der Randstruktur ist in Figur 2 dargestellt. Hier sind mehrere Feldplatten 15 dargestellt, die jeweils mit einem Feldring 17 verbunden sind, der als dotiertes Gebiet in das Substrat 1 eingebettet ist. In denjenigen Bereich der Randstruktur, der an die dotierten Gebiete 7, 8 angrenzt, ist vorgesehen, daß die Feldplatten 15 den jeweils angrenzenden Feldring 17 in Form einer Kaskode überlappen.

Im Gegensatz dazu ist im Bereich der Randstruktur, die im Bereich des Substratrandes 9 angeordnet ist, vorgesehen, daß keinerlei Überlappung der Feldplatten mit angrenzenden Feldplatten oder Feldringen vorgesehen ist.

Der Kanalstopper 16 wird wiederum durch eine Feldplatte 18 und ein dotiertes Gebiet 19 gebildet, die untereinander leitend verbunden sind. Allerdings ist nunmehr das dotierte Gebiet 19, das beispielsweise eine Dotierung vom Typ n aufweist, von einer weiteren Schicht mit entgegengesetztem Leitungstyp umgeben, also in diesem Fall von einer Schicht vom Typ p. Die Wirkung des Kanalstoppers wird damit weitgehend auf die Wirkung der Feldplatte 18 beschränkt.

In den Beispielen nach Figur 1 und 2 sind jeweils zwei dotierte Gebiete 7, 8 dargestellt, die durch zwei Gräben 10, 11 getrennt sind, wobei die Gräben untereinander und mit einer Gate-Elektrode 6 leitend verbunden sind. Es können jedoch auch mehr als nur zwei dotierte Gebiete 7, 8 vorgesehen sein, ebenso können auch mehr als nur zwei Gräben 10, 11 vorgesehen sein. Die Randstrukturen der Figuren 1 und 2 wurden nur beispielhaft dargestellt, es kann auch eine größere Anzahl von Feldplatten 15 und Feldringen 17 Anwendung finden, als in den Figuren 1 und 2 dargestellt wurde.

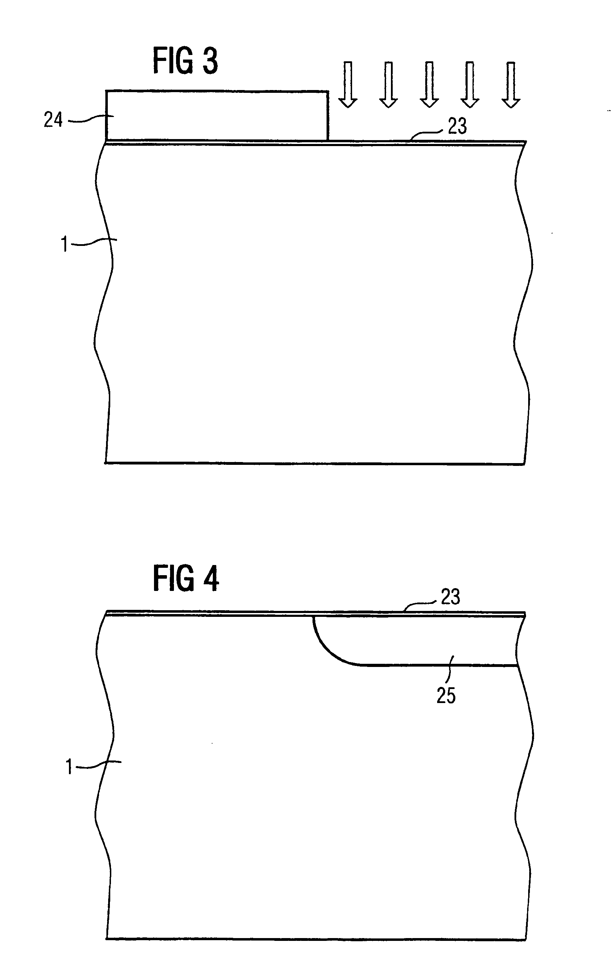

Figuren 3 bis 7 zeigen schematisch die Herstellungsschritte von zwei dotierten Gebieten 7, 8, die durch zwei Gräben 10, 11 voneinander getrennt sind. Hierzu erfolgt in einem ersten Schritt eine Implantation durch ein Streuoxid 23 in ein Substrat 1, wobei der übrige Bereich des Substrats durch eine Maske 24 abgedeckt ist. In einem ersten Diffusionsschritt wird ein Diffusionsgebiet 25 erzeugt, wobei die Tiefe dieses Gebietes 25 geringer ist als die gewünschte Tiefe des späteren, fertig ausdiffundierten Gebietes 8. Das Streuoxid 23 wird von der Substratoberfläche entfernt und es erfolgt die Strukturierung eines Grabens 11 in das Substrat, wobei dieser Graben 11 eine größere Tiefe aufweist als das Diffusionsgebiet 25, jedoch eine geringere Tiefe als das spätere, fertig ausdiffundierte Gebiet 8.

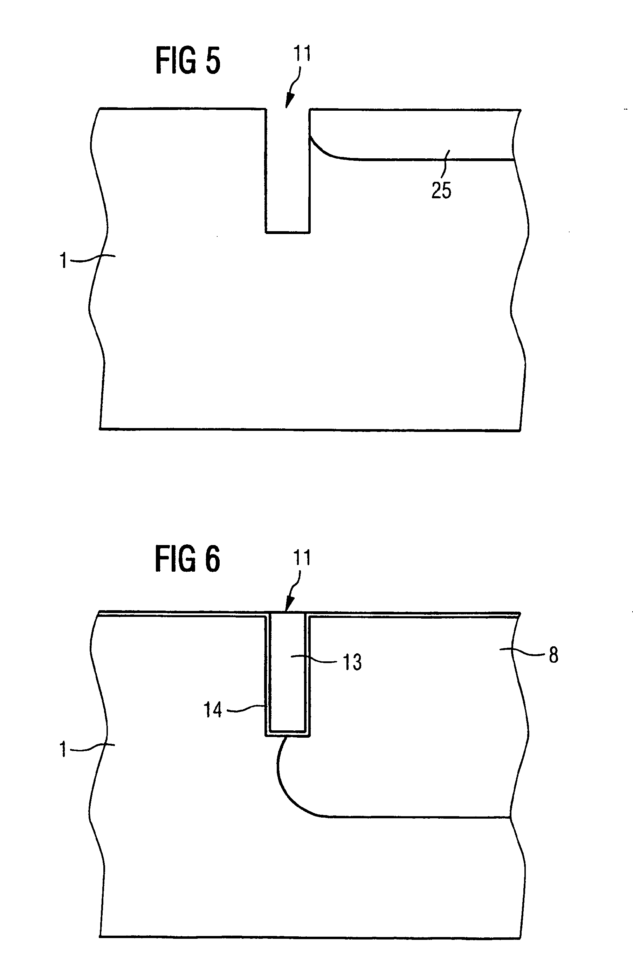

In einem zweiten Diffusionsschritt erfolgt die Ausdiffusion des Dotiermaterials bis in die gewünschte Tiefe des fertig ausdiffundierten Gebietes 8. Diese Tiefe kann dabei, wie in Figur 6 dargestellt, größer sein als die Tiefe des Grabens 11. Schließlich erfolgt die Bildung einer Isolationsschicht 14 auf der Substratoberfläche und den Innenwänden des Grabens 11, sowie das Auffüllen des Grabens mit einer leitenden Schicht 13. Grundsätzlich kann dieses Auffüllen des Grabens auch vor dem zweiten Diffusionsschritt zur endgültigen Bildung des Gebietes 8 erfolgen.

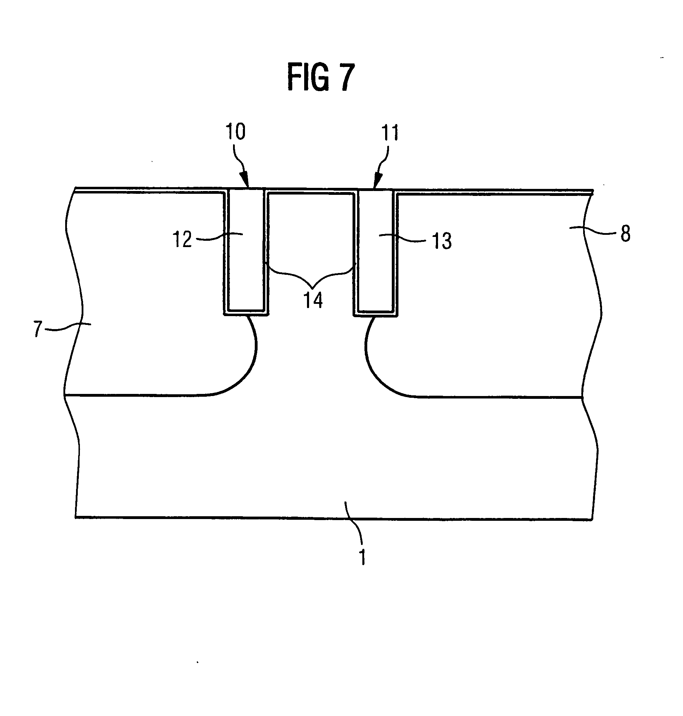

Die Bildung des zweiten dotierten Gebietes 7 sowie des zweiten Grabens 10 erfolgt parallel zur Bildung des Gebietes 8 sowie des Grabens 11. In den Figuren 3 bis 6 wurde aus Gründen der Einfachheit lediglich die Bildung des Gebietes 8 sowie des Grabens 11 dargestellt. Figur 7 zeigt die fertige Anordnung aus den beiden dotierten Gebieten 7 und 8, die durch zwei Gräben 10 und 11 voneinander getrennt sind. Beide Gräben sind mit einer leitenden Schicht 12, 13 gefüllt, die in einem gemeinsamen Schritt beispielsweise durch Abscheidung von Polysilizium erzeugt werden kann, wobei die leitende Schicht 12, 13 von einer Isolationsschicht 14 umgeben ist, die ebenfalls in einem gemeinsamen Schritt beispielsweise durch Oxidation des Substrats erzeugt werden kann.

## Patentansprüche

1. Halbleiteranordnung auf einem Substrat (1) ersten Leitungstyps mit
- einer Transistoranordnung (2) aus mindestens einem Feldeffekt-Transistor, bestehend aus mindestens zwei in das Substrat (1) eingebetteten dotierten Gebieten (3, 4) sowie mindestens einer Gate-Elektrode (5, 6),
- mindestens zwei voneinander getrennten Gebieten (7, 8) zweiten Leitungstyps, die zwischen der Transistoranordnung (2) und dem Substratrand (9) angebracht sind und sich von der Oberfläche des Substrats (1) in das Substrat (1) erstrecken und die die Transistoranordnung (2) umgeben,
**dadurch gekennzeichnet,**
**daß** zur Trennung der Gebiete (7, 8) zweiten Leitungstyps mindestens je zwei benachbarte, isolierende Grabengebiete (10, 11) vorgesehen sind, die zwischen den Gebieten (7, 8) zweiten Leitungstyps angeordnet sind und sich von der Oberfläche des Substrats (1) in das Substrat (1) erstrecken.

2. Halbleiteranordnung nach Anspruch 1,
**dadurch gekennzeichnet,**
**daß** die Grabengebiete (10, 11)eine geringere Tiefe aufweisen als die Gebiete (7, 8) zweiten Leitungstyps.

3. Halbleiteranordnung nach Anspruch 1 oder 2,
**dadurch gekennzeichnet,**
**daß** jedes Grabengebiet (10, 11) durch eine Isolationsschicht gebildet wird.

4. Halbleiteranordnung nach Anspruch 1 oder 2,
**dadurch gekennzeichnet,**
**daß** jedes Grabengebiet (10, 11) durch eine leitende Schicht (12, 13) gebildet wird, die von einer Isolationsschicht (14) umgeben ist.

5. Halbleiteranordnung nach Anspruch 4,
**dadurch gekennzeichnet,**
**daß** zumindest die leitenden Schichten (12, 13) benachbarter Grabengebiete (10, 11) untereinander leitend verbunden sind.

6. Halbleiteranordnung nach Anspruch 5,
**dadurch gekennzeichnet,**
**daß** zumindest die innersten benachbarten Grabengebiete (10, 11), die der Transistoranordnung (2) am nächsten liegen, mit einer Gate-Elektrode (6) oder einer Kathodenelektrode (3) der Transistoranordnung (2) leitend verbunden sind.

7. Halbleiteranordnung nach einem der Ansprüche 1 bis 6,
**dadurch gekennzeichnet,**
**daß** zumindest das innerste Gebiet (7) zweiten Leitungstyps, das an die Transistoranordnung (2) angrenzt, als floatendes Gebiet ausgebildet ist.

8. Halbleiteranordnung nach einem der Ansprüche 1 bis 7,
**dadurch gekennzeichnet,**
**daß** zumindest das äußerste Gebiet (8) zweiten Leitungstyps, das dem Substratrand (9) am nächsten liegt, mit den Kathodenelektroden (3) der Transistoranordnung (2) leitend verbunden ist.

9. Halbleiteranordnung nach einem der Ansprüche 1 bis 8,
**dadurch gekennzeichnet,**
**daß** zwischen den Gebieten (7, 8) zweiten Leitungstyps und dem Substratrand (9) ein Kanalstopper (16) und mindestens eine Feldplatte (15) und/oder ein Feldring (17) vorgesehen sind.

10. Halbleiteranordnung nach Anspruch 9,
**dadurch gekennzeichnet,**
**daß**
- mehrere Feldringe (17) und Feldplatten (15) vorgesehen sind und jeweils ein Feldring (17) mit einer Feldplatte (15) verbunden ist, wobei
- im Bereich der Transistoranordnung (2) eine Überlappung der Feldplatten (15) mit dem jeweils angrenzenden Feldring (17) in Form einer Kaskode vorgesehen ist.

11. Halbleiteranordnung nach einem der Ansprüche 9 oder 10,
**dadurch gekennzeichnet,**
**daß** der Kanalstopper (16) durch eine Schicht (19) ersten oder zweiten Leitungstyps gebildet wird, die am Rand (9) des Substrats (1) angeordnet ist und mit einer Feldplatte (18) verbunden ist.

12. Halbleiteranordnung nach Anspruch 11,
**dadurch gekennzeichnet,**
**daß** die Schicht (19) des Kanalstoppers (16) als Schicht ersten Leitungstyps ausgebildet ist und von einer Schicht (20) zweiten Leitungstyps umgeben ist.

13. Halbleiteranordnung nach einem der Ansprüche 9 bis 12,
**dadurch gekennzeichnet,**
**daß**
- die mindestens eine Feldplatte (15) mit der Kathodenelektrode (3) oder einer Gate-Elektrode (5, 6) der Transistoranordnung (2) leitend verbunden ist.

14. Verfahren zur Herstellung einer Halbleiteranordnung auf einem Substrat (1) ersten Leitungstyps, mit mindestens zwei voneinander getrennten Gebieten (7, 8) zweiten Leitungstyps, die sich von der Oberfläche des Substrats (1) in das Substrat (1) erstrecken,
**gekennzeichnet durch** die Schritte:
- Einbringen eines Dotierstoffes im Bereich der zu erzeugenden Gebiete (7, 8)
- Erzeugung je eines Grabens (10, 11) an derjenigen Grenze jedes der Gebiete (7, 8), die dem jeweils anderen Gebiet (7, 8) zugewandt ist, wobei der Graben eine Tiefe aufweist, die größer ist, als die Tiefe der Gebiete (7, 8) nach dem Einbringen des Dotierstoffes, jedoch geringer als die gewünschte Tiefe der Gebiete (7, 8)
- Ausdiffusion des Dotierstoffes in die gewünschte Tiefe, die größer ist, als die Tiefe der Gräben (10, 11)
- Auffüllen der Gräben (10, 11) unter Bildung einer isolierenden Schicht (12, 13, 14).

15. Verfahren nach Anspruch 14,
**dadurch gekennzeichnet,**
**daß** das Einbringen des Dotierstoffes mittels einer Implantation durch ein Streuoxid auf der Oberfläche des Substrats (1) erfolgt.

16. Verfahren nach einem der Ansprüche 14 oder 15,
**dadurch gekennzeichnet,**
**daß** zur Bildung der isolierenden Schicht (12, 13, 14) eine Isolationsschicht (14) auf der Innenseite der Gräben (10, 11) und auf der Oberfläche des Substrats (1) erzeugt wird und die Gräben anschließend mit einer leitenden Schicht (12, 13) gefüllt werden.

## Claims

1. Semiconductor arrangement on a substrate (1) of a first conduction type, having
- a transistor arrangement (2) formed from at least one field-effect transistor, comprising at least two doped regions (3, 4) embedded in the substrate (1), and also at least one gate electrode (5, 6),
- at least two regions (7, 8) of a second conduction type, which are isolated from one another, are provided between the transistor arrangement (2) and the substrate edge (9) and extend from the surface of the substrate (1) into the substrate (1) and surround the transistor arrangement (2),
**characterized in that**, in order to isolate the regions (7, 8) of the second conduction type, at least two adjacent, insulating trench regions (10, 11) in each case are provided, which are arranged between the regions (7, 8) of the second conduction type, and extend from the surface of the substrate (1) into the substrate (1).

2. Semiconductor arrangement as claimed in claim 1,
**characterized in that** the trench regions (10, 11) have a smaller depth than the regions (7, 8) of the second conduction type.

3. Semiconductor arrangement as claimed in claim 1 or 2,
**characterized in that** each trench region (10, 11) is formed by an insulation layer.

4. Semiconductor arrangement as claimed in claim 1 or 2,
**characterized in that** each trench region (10, 11) is formed by a conductive layer (12, 13) surrounded by an insulation layer (14).

5. Semiconductor arrangement as claimed in claim 4,
**characterized in that** at least the conductive layers (12, 13) of adjacent trench regions (10, 11) are conductively interconnected.

6. Semiconductor arrangement as claimed in claim 5,
**characterized in that** at least the innermost adjacent trench regions (10, 11), which are the nearest to the transistor arrangement (2), are conductively connected to a gate electrode (6) or a cathode electrode (3) of the transistor arrangement (2).

7. Semiconductor arrangement as claimed in one of claims 1 to 6,
**characterized in that** at least the innermost region (7) of the second conduction type, which adjoins the transistor arrangement (2), is designed as a floating region.

8. Semiconductor arrangement as claimed in one of claims 1 to 7,
**characterized in that** at least the outermost region (8) of the second conduction type, which is the nearest to the substrate edge (9), is conductively connected to the cathode electrodes (3) of the transistor arrangement.

9. Semiconductor arrangement as claimed in one of claims 1 to 8,
**characterized in that** a channel stopper (16) and at least one field plate (15) and/or a field ring (17) are provided between the regions (7, 8) of the second conduction type and the substrate edge (9).

10. Semiconductor arrangement as claimed in claim 9,
**characterized in that**
- a plurality of field rings (17) and field plates (15) are provided and a respective field ring (17) is connected to a field plate (15), where
- an overlap between the field plates (15) and the respectively adjoining field ring (17) in the form of a cascode is provided in the area of the transistor arrangement (2).

11. Semiconductor arrangement as claimed in either of claims 9 and 10,
**characterized in that** the channel stopper (16) is formed by a layer (19) of the first or second conduction type, which is arranged at the edge (9) of the substrate (1) and is connected to a field plate (18).

12. Semiconductor arrangement as claimed in claim 11,
**characterized in that** the layer (19) of the channel stopper (16) is designed as a layer of the first conduction type and is surrounded by a layer (20) of the second conduction type.

13. Semiconductor arrangement as claimed in one of claims 9 to 12,
**characterized in that**
- at least one field plate (15) is conductively connected to the cathode electrode (3) or a gate electrode (5, 6) of the transistor arrangement (2).

14. Method for fabricating a semiconductor arrangement on a substrate (1) of a first conduction type, having at least two regions (7, 8) of a second conduction type, which are isolated from one another and extend from the surface of the substrate (1) into the substrate (1),
**characterized by** the following steps:
- introduction of a dopant in the area of the regions (7, 8) to be produced,
- production of a trench (10, 11) in each case at that boundary of each of the regions (7, 8) which faces the respective other region (7, 8), where the trench has a depth which is greater than the depth of the regions (7, 8) after the introduction of the dopant but less than the desired depth of the regions (7, 8),
- outdiffusion of the dopant to the desired depth, which is greater than the depth of the trenches (10, 11),
- filling of the trenches (10, 11) with the formation of an insulating layer (12, 13, 14).

15. Method as claimed in claim 14,
**characterized in that** the dopant is introduced by means of implantation through a screen oxide on the surface of the substrate (1).

16. Method as claimed in either of claims 14 and 15,
**characterized in that**, in order to form the insulating layer (12, 13, 14), an insulation layer (14) is produced on the inside of the trenches (10, 11) and on the surface of the substrate (1) and the trenches are subsequently filled with a conductive layer (12, 13).

## Revendications

1. Dispositif à semi-conducteur sur un substrat (1) d'un premier type conducteur comprenant :
- un dispositif de transistor (2) comprenant au moins un transistor à effet de champ composé d'au moins deux zones dopées (3, 4) intégrées dans le substrat (1) et d'au moins une électrode de grille (5, 6),
- au moins deux zones (7, 8) séparées l'une de l'autre et d'un deuxième type conducteur, qui sont disposées entre le dispositif de transistor (2) et la bordure du substrat (9) et s'étendent de la surface du substrat (1) jusque dans le substrat (1) tout en entourant le dispositif de transistor (2),
**caractérisé en ce que**
pour séparer les zones (7, 8) du deuxième type conducteur, au moins deux zones de tranchées (10, 11) adjacentes et isolantes sont à chaque fois prévues entre les zones (7, 8) du deuxième type conducteur tout en s'étendant depuis la surface du substrat (1) jusque dans le substrat (1).

2. Dispositif à semi-conducteur selon la revendication 1,
**caractérisé en ce que**
les zones de tranchées (10, 11) présentent une profondeur plus petite que les zones (7, 8) du deuxième type conducteur.

3. Dispositif à semi-conducteur selon la revendication 1 ou 2,
**caractérisé en ce que**
chaque zone de tranchée (10, 11) est composée d'une couche isolante.

4. Dispositif à semi-conducteur selon la revendication 1 ou 2,
**caractérisé en ce que**
chaque zone de tranchée (10, 11) est composée d'une couche conductrice (12, 13) entourée par une couche isolante (14).

5. Dispositif à semi-conducteur selon la revendication 4,
**caractérisé en ce qu'**
au moins les couches conductrices (12, 13) de zones de tranchées adjacentes (10, 11) sont reliées entre elles de manière conductrice.

6. Dispositif à semi-conducteur selon la revendication 5,
**caractérisé en ce qu'**
au moins les zones de tranchées adjacentes (10, 11) les plus à l'intérieur, situées au plus près du dispositif de transistor (2), sont reliées de manière conductrice à une électrode de grille (6) ou à une électrode cathodique (3) du dispositif de transistor (2).

7. Dispositif à semi-conducteur selon l'une des revendications 1 à 6,
**caractérisé en ce qu'**
au moins la zone la plus à l'intérieur (7) du deuxième type conducteur, qui est adjacente du dispositif de transistor (2), est réalisée sous la forme d'une zone flottante.

8. Dispositif à semi-conducteur selon l'une des revendications 1 à 7,
**caractérisé en ce qu'**
au moins la zone la plus à l'extérieur (8) et du deuxième type conducteur, qui est située au plus près de la bordure du substrat (9), est reliée de manière conductrice aux électrodes cathodiques (3) du dispositif de transistors (2).

9. Dispositif à semi-conducteur selon l'une des revendications 1 à 8,
**caractérisé par**
un système d'obturation de canal (16) et au moins une plaque de champ (15) et/ou un anneau de champ (17) prévus entre les zones (7, 8) du deuxième type conducteur et la bordure du substrat (9).

10. Dispositif à semi-conducteur selon la revendication 9,
**caractérisé en ce que**
- plusieurs anneaux de champ (17) et plaques de champ (15) sont prévus avec chaque fois un anneau de champ (17) relié à une plaque de champ (15), et
- au niveau du dispositif de transistors (2), un chevauchement des plaques de champ (15) avec l'anneau de champ (17) qui lui est adjacent est prévu chaque fois sous la forme d'un cascode.

11. Dispositif à semi-conducteur selon l'une des revendications 9 ou 10,
**caractérisé en ce que**
le système d'obturation de canal (16) est formé par une couche (19) du premier ou deuxième type conducteur disposée au niveau de la bordure (9) du substrat et reliée à une plaque de champ (18).

12. Dispositif à semi-conducteur selon la revendication 11,
**caractérisé en ce que**
la couche (19) du système d'obturation du canal (16) est réalisée sous la forme d'une couche du premier type conducteur et entourée par une couche (20) du deuxième type conducteur.

13. Dispositif à semi-conducteur selon l'une des revendications 9 ou 12,
**caractérisé en ce que**
l'au moins une plaque de champ (15) est reliée de manière conductrice à l'électrode cathodique (3) ou à une électrode de grille (5, 6) du dispositif de transistor (2).

14. Procédé de fabrication d'un dispositif à semi-conducteur sur un substrat (1) d'un premier type conducteur, comprenant au moins deux zones séparées l'une de l'autre (7, 8) et d'un deuxième type conducteur et qui s'étendent depuis la surface du substrat (1) jusque dans le substrat (1),
**caractérisé par**
les étapes consistant à :
- introduire une substance de dopage au niveau des zones à produire (7, 8),
- produire à chaque fois une tranchée (10, 11) à la frontière de chacune des zones (7, 8) qui est tournée à chaque fois vers l'autre zone (7, 8), les tranchées présentant une profondeur supérieure à la profondeur des zones (7, 8) après avoir introduit la substance de dopage, mais inférieure à la profondeur souhaitée des zones (7, 8),
- diffuser la substance de dopage dans la profondeur souhaitée, supérieure à la profondeur des tranchées (10, 11), et
- remplir les tranchées (10, 11) en formant une couche isolante (12, 13, 14).

15. Procédé selon la revendication 14,
**caractérisé en ce que**
l'introduction de la substance de dopage s'effectue au moyen d'une implantation par un oxyde de dispersion sur la surface du substrat (1).

16. Procédé selon l'une des revendications 14 ou 15,
**caractérisé en ce que**
pour former la couche isolante (12, 13, 14), une couche isolante (14) est produite sur la face intérieure des tranchées (10, 11) et sur la surface du substrat (1) et les tranchées sont ensuite remplies d'une couche conductrice (12, 13).
